# EUROPÄISCHE PATENTSCHRIFT

(11) **EP 0 574 976 B1**
(45) Veröffentlichungstag und Bekanntmachung des Hinweises auf die Patenterteilung: **16.09.1998**
(21) Anmeldenummer: 93201614.0
(22) Anmeldetag: 07.06.1993
(51) Int. Cl.: G11C 16/06

(54) **Speicheranordnung und Verfahren zu deren Betrieb**
Memory device and its operating method
Dispositif de mémoire et méthode de son opération

(30) Priorität: 13.06.1992 DE 4219464
(43) Veröffentlichungstag der Anmeldung: 22.12.1993
(73) Patentinhaber: Philips Patentverwaltung GmbH, 22335 Hamburg (DE); Koninklijke Philips Electronics N.V., 5621 BA Eindhoven (NL)
(72) Erfinder: Frerichs, Heinz-Peter, Dr. rer. nat., D-79271 St.Peter (DE)
(74) Vertreter: Poddig, Dieter, Dipl.-Ing.

(56) Entgegenhaltungen:
- GB-A- 2 146 145
- US-A- 4 954 990
- IEEE JOURNAL OF SOLID-STATE CIRCUITS., Bd.26, Nr.11, November 1991, NEW YORK US Seiten 1593 - 1599 TOMITA ET AL 'A 62ns 16Mb CMOS EPROM with voltage stress relaxation technique'

## Beschreibung

Die Erfindung betrifft eine integrierte Speicheranordnung mit einer Matrix aus adressierbaren, elektrisch programmierbaren Speicherzellen, die je einen MOS-Transistor mit einem schwebenden, mittels einer Programmierspannung umladbaren Gate und einem Steuergate enthalten, und mit einer Steuerschaltung, die einen Spannungseingang zum Zuführen einer Hochspannung größer als die gewünschte Programmierspannung, einen Spannungsausgang zum Abgeben der Programmierspannung und einen zusätzlichen Transistor umfaßt, der gleich den Transistoren der Speicherzellen aufgebaut ist und dazu vorgesehen ist, aus der Hochspannung eine Programmierspannung mit nahezu optimalem Wert entsprechend Fertigungstoleranzen abzuleiten.

Eine derartige Speicheranordnung ist bekannt aus der US-PS 4,954,990. Speicher mit Speicherzellen, die je einen MOS-Transistor mit einem schwebenden Gate enthalten, werden als EPROMs bezeichnet. Dies bedeutet, daß die einzelnen Speicherzellen elektrisch programmierbar sind. Jede Speicherzelle enthält ein Bit mit einem Wert, der davon abhängt, ob das schwebende Gate des Speicherzellen-Transistors aufgeladen, d.h. programmiert ist oder nicht. Das Programmieren erfolgt mit Hilfe einer Programmierspannung, die bestimmten Anschlüssen des Transistors der gewünschten Speicherzelle zugeführt wird, um auf dem schwebenden Gate eine Ladung zu speichern.

Der Wert der Programmierspannung muß einigermaßen genau gesteuert sein. Wenn die Programmierspannung zu hoch ist, kann die Speicherzelle während der Programmierung zerstört oder zumindest geschädigt werden, so daß eine häufige Umprogrammierung nicht mehr möglich ist. Wenn die Programmierspannung zu niedrig ist, werden die einzelnen Speicherzellen nicht eindeutig programmiert, d.h. beim Auslesen ist nicht eindeutig erkennbar, welcher Wert gespeichert sein sollte. Der Spannungsbereich der Programmierspannung, bei dem weder ein Schädigung der Speicherzellen auftritt und trotzdem eine eindeutige Programmierung der Speicherzellen möglich ist, hängt jedoch in einem gewissen Maß von Fertigungstoleranzen bei der Herstellung des integrierten Speichers ab und ist nur schwer von außerhalb des Speichers feststellbar. Dadurch ist es praktisch nicht möglich, einen Wert der Programmierspannung anzugeben, der für verschiedene hergestellte Speicher in dem individuell optimalen Spannungsbereich des jeweiligen Speichers liegt.

Bei der bekannten Speicheranordnung gemäß der genannten US-PS 4,954,990 wird nun mit Hilfe eines zusätzlichen Transistors, der die gleichen Eigenschaften hat wie die Transistoren der Speicherzellen, die der eigentlichen Speichermatrix zugeführte Programmierspannung so von einer höheren Programmierspannung oder Hochspannung abgeleitet, daß die Programmierspannung einen für den betreffenden Speicher weitgehend optimalen Wert hat. Dazu wird der Strom durch den zusätzlichen Transistor beim Anlegen der Hochspannung gemessen, und abhängig von diesem Strom wird über mehrere Stromspiegel die Programmierspannung so beeinflußt, daß bei einem höheren Strom die Programmierspannung verringert wird. Diese Schaltung benötigt jedoch noch weitere Spannungsteiler sowie eine größere Anzahl von Bauelementen und arbeitet nicht sehr zuverlässig.

Aufgabe der Erfindung ist es, eine Speicheranordnung der eingangs genannten Art so auszugestalten, daß damit eine einfache und zuverlässige Einstellung der Programmierspannung auf einen weitgehend optimalen Wert möglich ist.

Diese Aufgabe wird erfindungsgemäß dadurch gelöst, daß die Source des zusätzlichen Transistors mit dem Spannungsausgang verbunden ist, daß die Drain des zusätzlichen Transistors über einen ersten Schalter mit einem Steuerspannungseingang und über einen zweiten Schalter mit dem Spannungseingang koppelbar ist und daß das Steuergate des zusätzlichen Transistors über einen dritten Schalter mit der Bezugsspannung und wenigstens über einen vierten Schalter mit dem Spannungseingang koppelbar ist.

Durch entsprechende Steuerung der Schalter in der der Steuerschaltung erfindungsgemäßen Speicheranordnung ist es möglich, den zusätzlichen Transistor derart zu programmieren, daß an seiner Source die von Fertigungstoleranzen abhängige optimale Programmierspannung weitgehend genau abgegeben wird. Die Einstellung der Programmierspannung erfolgt zuverlässig auf einen weitgehend optimalen Wert, da für diese Einstellung nur die Eigenschaften des zusätzlichen Transistors verwendet werden, jedoch keine weiteren Elemente.

Da EPROM-Speicher und insbesondere EEPROM-Speicher ausschließlich mit MOS-Transistoren aufgebaut sind und die Steuerschaltung zur Erzeugung der Programmierspannung einen Teil der integrierten Speicheranordnung bildet, ist es zweckmäßig, die Schalter darin ebenfalls mit MOS-Transistoren aufzubauen. Eine Ausgestaltung der Erfindung ist daher dadurch gekennzeichnet, daß bei Ausführung der Transistoren der Speicherzellen als N-Kanal-MOS-Transistoren der erste und der dritte Schalter als N-Kanal-MOS-Transistoren und der zweite und der vierte Schalter als P-Kanal-MOS-Transistoren ausgebildet sind, wobei die Gates des ersten und zweiten Schalters gemeinsam über einen ersten Steuereingang und die Gates des dritten und vierten Schalters gemeinsam über einen zweiten Steuereingang steuerbar sind. Mit diesem Aufbau ist es möglich, daß die erfindungsgemäße Speicheranordnung über nur zwei Steuereingänge vollständig steuerbar ist, um die Erzeugung der gewünschten Programmierspannung einzustellen.

Bei der Programmierung des Speichers wird dem Transistor der ausgewählten Speicherzelle die Programmierspannung nicht direkt zugeführt, sondern über eine Auswahlschaltung, die zumindest einen Teil der Adressendekodierung umfaßt. Um dies bei der Einstellung des zusätzlichen Transistors zum Erzeugen der optimalen Programmierspannung zu berücksichtigen, ist eine weitere Ausgestaltung der Erfindung dadurch gekennzeichnet, daß zwischen dem vierten Schalter und dem Steuergate des zusätzlichen Transistors ein weiterer N-Kanal-MOS-Transistor, dessen Gate mit dem mit dem vierten Schalter verbundenen Anschluß verbunden ist, geschaltet ist und daß über einen fünften Schalter, der ebenfalls als P-Kanal-MOS-Transistor ausgebildet ist und über den ersten Steuereingang steuerbar ist, das Steuergate des zusätzlichen Transistors mit dem Spannungseingang koppelbar ist. Der weitere Transistor bildet dabei also die Auswahlschaltung nach, während im normalen Betrieb dieser weitere Transistor durch den fünften Schalter quasi überbrückt ist, so daß die Spannung am Steuergate den eingestellten Schwellwert des zusätzlichen Transistors nicht mehr beeinflußt.

Ein Verfahren zum Betrieb der erfindungsgemäßen Speicheranordnung, um eine Programmierspannung mit einem weitgehend optimalen Wert von einer Hochspannung auf einfache und zuverlässige Weise abzuleiten, ist efindungsgemäß dadurch gekennzeichnet, daß die Programmierspannung an der Source des zusätzlichen Transistors erzeugt wird, dessen Drain im normalen Speicherbetrieb mit der Hochspannung gekoppelt wird und dessen Steuergate im wesentlichen auf dem Potential der Hochspannung liegt, und daß wenigstens vor dem erstmaligen Betrieb des Speichers dem zusätzlichen Transistor in einem ersten Einstellschritt an seinem Steuergate eine niedrige Spannung und an seiner Drain im wesentlichen die Hochspannung während einer Zeitdauer zugeführt wird, die ausreicht, um den zusätzlichen Transistor vollständig zu programmieren und damit in den selbstleitenden Zustand zu bringen, und in einem zweiten Einstellschritt an seinem Steuergate im wesentlichen die Hochspannung und an seiner Drain eine entsprechend den gewünschten Eigenschaften des Speichers im Betrieb zwischen der Bezugsspannung und einem Bruchteil der Hochspannung liegende Einstellspannung während einer Zeitdauer entsprechend der Programmierzeitdauer der Speicherzellen zugeführt wird.

Es werden also erfindungsgemäß die Speichereigenschaften des zusätzlichen Transistors ausgenutzt, indem dieser vor dem erstmaligen Betrieb des Speichers auf einen derartigen Schwellwert programmiert wird, der im wesentlichen der Differenz zwischen der Hochspannung und der für die Programmierung des zusätzlichen Transistors und damit auch der Transistoren der Speicherzellen erforderlichen Programmierspannung entspricht. Für den normalen Betrieb wird der zusätzliche Transistor dann also als Source-Folger mit der programmierten Schwellspannung betrieben.

Ausführungsbeispiele der Erfindung werden nachstehend anhand der Zeichnung näher erläutert. Es zeigen:
Fig. 1 eine erfindungsgemäße Speicheranordnung mit einer Steuerschaltung für die Programmierspannung,
Fig. 2a bis 2c die Elemente dieser Steuerschaltung, die in den einzelnen Einstellschritten bzw. im Normalbetrieb jeweils wirksam sind.

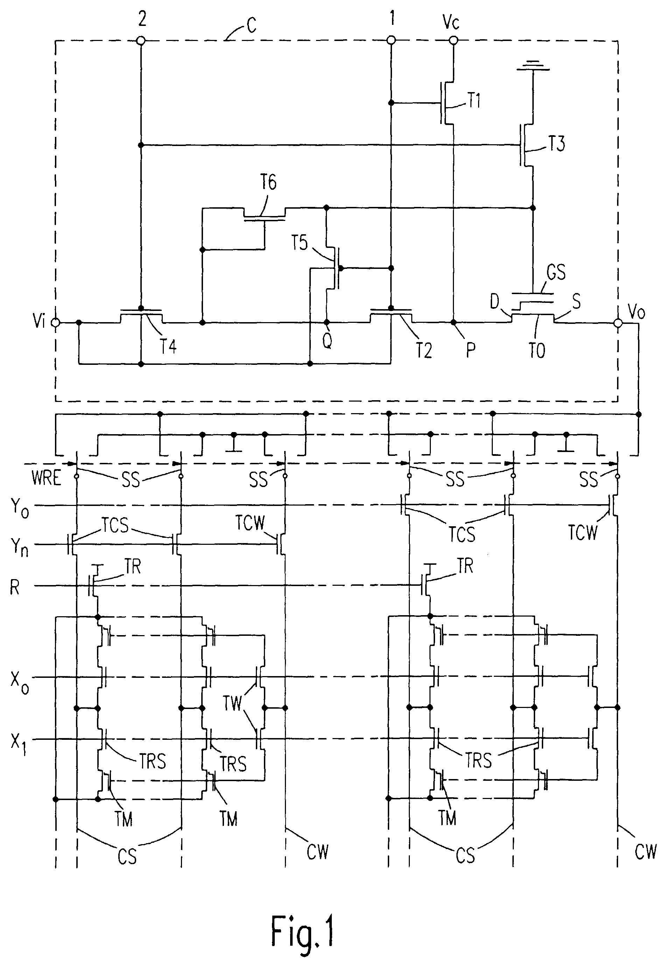

In dem unteren Teil der Fig. 1 sind ein Teil der Elemente einer Speicheranordnung dargestellt, die Speichertransistoren TM mit einem schwebenden, umladbaren Gate enthält. Ferner sind eine Anzahl Auswahltransistoren TRS und TCS vorgesehen. Jedem Speichertransistor TM ist ein Auswahltransistor TRS zugeordnet. Diese Paare von Speichertransistoren TM und Auswahltransistor TRS sind in Form einer Matrix aus Reihen und Spalten angeordnet, von denen hier der Übersichtlichkeit halber nur die ersten beiden Reihen der ersten und der letzten Spalte dargestellt sind. Die einzelnen Reihen der Matrix werden durch Reihenadreßleitungen X₀, X₁, usw. ausgewählt, die von einem nicht dargestellten Adressendekoder angesteuert werden. In jeder Spalte werden die Bits eines Speicherwortes parallel eingeschrieben bzw. ausgelesen, wobei hier der Übersichtlichkeit halber nur die Elemente des ersten und des letzten Bits jeweils eines Speicherwortes angedeutet sind.

Die einzelnen Spalten werden über Spaltenauswahlleitungen CS ausgewählt, mit denen das eine Ende von Reihenschaltungen eines Speichertransistors TM und eines Auswahltransistors TRS verbunden ist. Die Auswahlleitungen CS sind mit Spaltenauswahltransistoren TCS verbunden, die von Spaltenadreßleitungen Y₀ bis Yₙ (für eine Matrix mit n+1 Spalten) angesteuert werden, die ihrerseits von nicht dargestellten Adreßdekodierern gespeist werden. Die Spaltenadreßleitungen Y₀ bis Yₙ steuern ferner Schreibauswahltransistoren TCW an, die mit Schreibauswahlleitungen CW verbunden sind, die nur im Schreibmodus und zusätzlich auch im Löschmodus wirksam sind.

Die anderen Enden der Auswahltransistoren TCS und TCW sind mit Auswahlschaltern SS verbunden, die drei Stellungen aufweisen und die hier nur vereinfacht als mechanischer Umschalter dargestellt sind, die praktisch jedoch ebenfalls mittels Transistoren realisiert sind und gemeinsam angesteuert werden, um einen Schreibmodus, Lesemodus oder einen Löschmodus des Speichers einzustellen.

In der linken, in Fig. 1 nicht dargestellten Stellung der Auswahlschalter SS werden die Auswahltransistoren TCS mit einer Leitung für eine Programmierspannung verbunden, die von einem Ausgang Vo einer Steuerschaltung C im oberen Teil der Fig. 1 geliefert wird. Zusätzlich erfolgt jedoch auch noch eine Steuerung durch die einzuschreibende Information, was in Fig. 1 nicht dargestellt ist, d.h. nur die Auswahltransistoren TCS für diejenigen Bits des einzuschreibenden Worts, die den einen binären Wert haben, werden mit der Programmierspannung verbunden. Damit führen die Spaltenauswahlleitungen CS der Spalte, die durch die Spaltenadreßleitung Y angesteuert wird, abhängig von der einzuschreibenden Information ebenfalls die Programmierspannung. Da gleichzeitig nur eine der Reihenadreßleitungen, beispielsweise X₁, angesteuert wird, liegt über die dadurch leitend geschalteten Reihenauswahltransistoren TRS an dem einen Anschluß der Gruppe von Speichertransistoren TM, abhängig von der einzuschreibenden Information, die Programmierspannung.

Gleichzeitig wird in dieser linken Stellung der Auswahlschalter SS den Auswahltransistoren TCW ein Bezugspotential, beispielsweise Massepotential, zugeführt, so daß in der ausgewählten Spalte die Auswahl leitung CW ebenfalls dieses Bezugspotential führt. Über den Auswahltransistor TW, der mit dieser Auswahlleitung CW verbunden ist und der gleichzeitig von der Reihenadreßleitung angesteuert wird, wird also den Gates der Speichertransistoren, die über die ausgewählten Spaltenleitungen CS und die ausgewählten Reihenauswahltransistoren TRS die Programmierspannung erhalten, das Bezugspotential zugeführt, so daß nunmehr zwischen dem betreffenden Anschluß der Speichertransistoren TM und den Gates dieser Transistoren die Programmierspannung liegt, wodurch das schwebende Gate dieser Speichertransistoren mit Hilfe des Tunneleffektes aufgeladen wird.

Im Lesemodus sind in der mittleren, dargestellten Stellung der Auswahlschalter SS die einen Anschlüsse der Auswahltransistoren TCS offen, und gleichzeitig werden über den Eingang R Lesetransistoren TR angesteuert, die die einen Anschlüsse aller Speichertransistoren TM mit Bezugspotential verbinden. Die Speichertransistoren TM, deren schwebendes Gate beim Schreiben aufgeladen wurde, verbinden nun dieses Bezugspotential relativ niederohmig mit dem einen Anschluß der zugehörigen Reihenauswahltransistoren TRS, und abhängig von der durch die Reihenadreßleitung X ausgewählte Reihe wird dieses Potential auf die Leitungen CS übertragen, die in diesem Falle als Leseleitungen arbeiten. Da nur eine der Spaltenadreßleitungen Y angesteuert wird, werden die Leitungen CS nur einer Spalte zu den Auswahlschaltern SS durchgeschaltet, von denen in der dargestellten Stellung nun das ausgelesene Wort abgenommen werden kann.

In der rechten Stellung der Auswahlschalter SS, die den Löschmodus des Speichers bestimmt, werden die Spaltenauswahlleitungen CS der ausgewählten Spalte mit dem Bezugspotential verbunden, und über die ausgewählten Reihenauswahltransistoren TRS wird dieses Bezuspotential dem einen Anschluß der Speichertransistoren TM eines ausgewählten Speicherwortes zugeführt. Gleichzeitig wird über den Auswahltransistor TCW der ausgewählten Spalte der Spaltenleitung CW die Programmierspannung zugeführt, die über den ausgewählten Auswahltransistor TW den Gates der Speichertransistoren TM des ausgewählten Datenwortes zugeführt wird, wodurch eine eventuell vorhandene Ladung auf den schwebenden Gates dieser Speichertransistoren mit Hilfe des Tunneleffektes wieder entfernt wird.

Die Programmierspannung, die beim Schreiben und Löschen zwischen dem einen Anschluß und dem Gate der Speichertransistoren eines ausgewählten Speicherwortes liegt, muß so groß sein, daß während der Zeitdauer des Schreibens bzw. des Löschens dieser Transistoren eine ausreichende Ladungsmenge auf das schwebende Gate transportiert bzw. von diesem abtransportiert wird. Andererseits darf diese Programmierspannung jedoch nicht wesentlich größer sein, da sonst diese Speichertransistoren beschädigt werden und die Anzahl von Schreib- und Löschzyklen verringert bzw. die Fehlerrate erhöht wird. Um dies zu erreichen, wird die Programmierspannung der Speicheranordnung von einer Steuerschaltung C erzeugt, die in Fig. 1 oben dargestellt ist.

Darin weist ein Transistor T0 der ebenso aufgebaut ist wie die Speichertransistoren TM der Speichermatrix, ein schwebendes Gate und ein Steuergate GS auf. Die Source S des Transistors T0 ist mit einem Spannungsausgang Vo verbunden, an dem die Programmierspannung für den Speicher abnehmbar ist. Die Drain D des Transistors T0 ist mit einem Schaltungspunkt P verbunden, der über einen ersten MOS-Transistor T1 mit einem Einstellspannungseingang Vc oder über die Reihenschaltung von einem zweiten Transistor T2 und einem vierten Transistor T4, die beide als P-Kanal-MOS-Transistoren ausgebildet sind, mit dem Spannungseingang Vi verbindbar ist, dem die Hochspannung zugeführt wird. Üblicherweise wird die Hochspannung von einem Hochspannungsgenerator aus einer niedrigeren Betriebsspannung des Speichers erzeugt, der ebenso wie die in Fig. 1 dargestellte Schaltungsanordnung zusammen mit dem Speicher und den zugehörigen Adressenauswahlschaltungen integriert ist.

Das Steuergate GS des Transistors T0 ist über einen dritten Transistor T3 mit einer Bezugsspannung und über die Reihenschaltung eines als eine Art Diode mit festem Spannungsabfall geschalteten Transistors T6 und dem Transistor T4 mit dem Spannungseingang Vi verbindbar. Ferner ist das Steuergate GS über einen fünften P-Kanal-MOS-Transistor T5 mit einem Schaltungspunkt Q verbindbar, der die Verbindung der beiden Transistoren T2 und T4 bildet. Alle Transistoren Tl bis T6, also außer dem Transistor TO sind übliche selbstsperrende MOS-Transistoren. Die Gates der Transistoren Tl, T2 und T5 sind mit einem ersten Steuereingang 1 verbunden, und die Gates der Transistoren T3 und T4 sind mit einem zweiten Steuereingang 2 verbunden.

Zum Einstellen der Programmierspannung am Spannungsausgang Vo werden den Steuereingängen 1 und 2 sowie dem Einstellspannungseingang Vc während zweier aufeinanderfolgender Einstellschritte und während des anschließenden Normalbetriebs Spannungen zugeführt, wie in der Tabelle angegeben ist, wobei dem Spannungseingang Vi ständig eine konstante Hochspannung Vh zugeführt wird.

**TABELLE**

| | Schritt 1 | Schritt 2 | normaler Betrieb |
|---|---|---|---|
| 1 | ≥ Vh | ≥ Vh | 0V |
| 2 | ≥ Vh | 0V | 0V |
| Vc | Vh | 0...5V | -- |

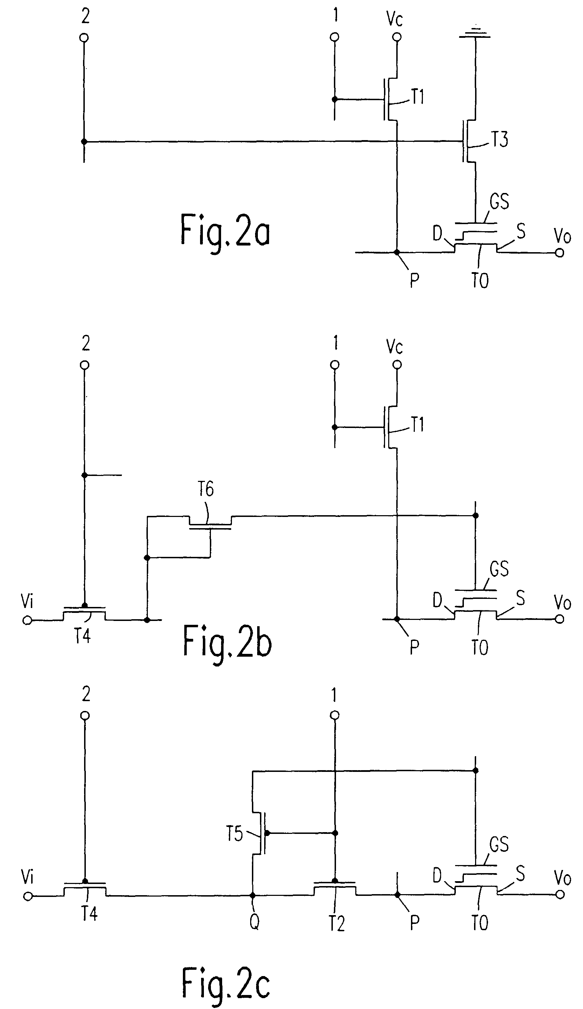

Im Schritt 1 erhält der Einstellspannungseingang also die Hochspannung Vh, die auch am Spannungseingang Vi liegt. Die Steuereingänge 1 und 2 erhalten ebenfalls die Hochspannung Vh oder gegebenenfalls eine höhere Spannung, von der die Hochspannung Vh durch eine Stabilisierungsschaltung abgeleitet ist. Der genaue Wert dieser Spannungen ist nicht kritisch, da es nur darauf ankommt, daß in diesem Schritt die Transistoren T2, T4 und T5 gesperrt und die Transistoren T1 und T3 leitend sind. Dies ist bereits der Fall, wenn die Spannungen an den Steuereingängen 1 und 2 gleich der Hochspannung Vh sind, da der Transistor T4 selbstsperrend ist und somit der Schaltungspunkt Q schwebt, während der Transistor T3 üblicherweise eine Schwellspannung aufweist, die weit unterhalb der Hochspannung liegt, so daß dieser Transistor mit Sicherheit eingeschaltet ist und das Steuergate GS des Transistors T0 mit Bezugspotential verbindet, wie in Fig. 2a angedeutet ist. Der Schaltungspunkt P liegt über den Transistor T1 auf einer Spannung, die um die Schwellspannung des Transistors T1 niedriger ist als die Spannung am Steuereingang 1, jedoch höchstens auf der Spannung am Einstellspannungseingang Vc. Damit wird der Transistor T0 programmiert, d.h. er gelangt in den selbstleitenden Zustand, in dem er praktisch ohne Spannungsabfall leitend ist. Hieraus wird klar, daß die Spannung am Steuereingang 1 nicht genau definiert sein muß, solange sie nur ausreicht, den Transistor T0 sicher in diesen angegebenen Zustand zu bringen.

Ausgehend von diesem eindeutig definierten Zustand des Transistors T0 erfolgt nun der zweite Schritt des Einstellvorgangs, bei dem der Steuereingang 2 im wesentlichen Bezugspotential erhält und an den Einstellspannungseingang Vc eine Spannung zwischen der Bezugsspannung und einem Bruchteil der Hochspannung angelegt wird. Der genauere Wert dieser Spannung wird später erläutert werden. Der Steuereingang 1 erhält weiterhin eine hohe Spannung.

In Fig. 2b ist angedeutet, welche Transistoren nun wirksam sind. Der Transistor T3 ist gesperrt und damit unwirksam, da es sich um einen selbstsperrenden Typ handelt, wie bereits erwähnt, und der eine Anschluß und das Gate beide mit Bezugspotential verbunden sind. Der Transistor T1 ist dagegen jetzt vollständig ohne Spannungsabfall leitend, da die Spannung am Steuereingang 1 und damit an seinem Gate wesentlich positiver ist als die Spannung am Einstellspannungseingang Vc, die damit auch die Spannung des Schaltungsknotens P und somit die Spannung an der Drain D des Transistors T0 bestimmt.

Durch die niedrige Spannung am Steuereingang 2 ist nun der Transistor T4 leitend, so daß der Schaltungsknoten Q nun ebenfalls auf der Hochspannung Vh liegt, die auch dem Spannungseinang Vi zugeführt wird, und diese Hochspannung wird um die Schwellspannung des Transistors T6 verringert dem Gate GS des Transistors T0 zugeführt. Der Transistor T6 vertritt die Zugriffstransistoren in der Speichermatrix, wodurch die Transistoren in den Speicherzellen darin eine um diese Schwellspannung der Zugriffstransistoren niedrigere Spannung als die Programmierspannung erhalten.

Zunächst wird angenommen, daß die Spannung am Einstellspannungseingang Vc und damit auch am Schaltungspunkt P und an der Drain D des Transistors T0 gleich der Bezugsspannung ist. Dadurch wird der Transistor T0 nun umprogrammiert, d.h. teilweise gelöscht im Sprachgebrauch bei EEPROMs, so daß die Schwellspannung des Transistors T0 zu positiven Werten verschoben wird. Der Wert der Schwellspannung, die sich dabei einstellt, hängt von verschiedenen Einflüssen ab. Zunächst ist die Verschiebung um so größer, je höher der Wert der Hochspannung ist. Da der Generator für die Erzeugung der Hochspannung auf dem Chip des Speichers selbst integriert ist, wird auf diese Weise ein dauernder Ausgleich bezüglich des Werts dieser Hochspannung erreicht. Wenn andererseits die herstellungsbedingten Eigenschaften des Transistors T0 beispielsweise eine geringere Programmierspannung benötigen, wird bei vorgegebenen, an die Drain D und das Steuergate GS angelegten Spannungen die Schwellspannung automatisch größer, und damit wird auch die Programmierspannung im normalen Betriebsfall niedriger, da die Transistoren der Speicherzellen ebenso wie der zusätzliche Transistor T0 eine niedrigere Programmierspannung benötigen. Im umgekehrten Fall, d.h. bei einer höheren benötigten Programmierspannung, gilt das Entsprechende. Auf diese Weise werden Fertigungstoleranzen des Speichers, die sich auf die notwendige bzw. optimale Programmierspannung der einzelnen Speichertransistoren auswirken, weitgehend automatisch ausgeregelt.

Einen weiteren Einfluß hat die Dauer des zweiten Schritts beim Einstellvorgang, in dem die angegebenen Spannungen zugeführt werden. Zwar existiert ein Sättigungswert der Schwellspannung für den zusätzlichen Transistor, der nach einer genügend langen Zeit erreicht wird, jedoch wird im normalen Betrieb des Speichers der Programmiervorgang eine merkliche Zeit vor Erreichen des Endzustandes abgebrochen, um den Schreib- und Löschvorgang des Speichers zu beschleunigen, und um diesen Einfluß zu berücksichtigen, ist es zweckmäßig, daß die Dauer des zweiten Schritts beim Einstellvorgang im wesentlichen gleich der Programmierdauer der Speicherzellen im normalen Betrieb ist. Durch eine Verlängerung der Zeitdauer des zweiten Schritts kann die Schwellspannung des Transistors T0 erhöht werden, ebenso wie Schwellspannung niedriger eingestellt wird, wenn der zweite Schritt eine kürzere Zeitdauer hat als die normale Programmierzeitdauer im Betrieb des Speichers, die häufig ebenfalls durch einen auf dem Chip des Speichers integrierten Oszillator bestimmt wird.

Eine weitere Einflußmöglichkeit besteht in dem Wert der Einstellspannung am Einstellspannungseingang. Wenn dieser Wert größer ist als die Bezugsspannung, ist die Spannungsdifferenz zwischen Steuergate GS und Drain D des Transistors T0 geringer als die Programmierspannung, die die Transistoren der Speicherzellen im normalen Betrieb erhalten, so daß diese dann zwar einem leicht erhöhten Spannungsstreß ausgesetzt sind, jedoch in kürzerer Zeit einen eindeutig programmierten Zustand erreichen. Mit der Spannung am Einstellspannungseingang Vc kann also in einem gewissen Maß bestimmt werden, mit welcher Programmierzeitdauer der Speicher später im Betrieb zuverlässig betrieben werden kann.

Der beschriebene Einstellvorgang, um eine Programmierspannung mit einem weitgehend herstellungsbedingten optimalen Wert zu erzeugen, braucht nur einmal vor dem ersten Betrieb des Speichers, beispielsweise als Abschluß des Herstellungs- und Testvorgangs zu erfolgen, da die Einstellung von Transistoren mit schwebendem Gate sehr zuverlässig langzeitstabil ist, ebenso wie auch gespeicherte Daten über lange Zeit speicherbar sind. Falls gewünscht, läßt sich der Einstellvorgang jedoch jederzeit wiederholen, beispielsweise auch bei jedem Einschalten eines Geräts, in das der Speicher eingebaut ist.

Im normalen Betrieb erhalten beide Steuereingänge 1 und 2 Bezugspotential, so daß der Transistor T1 gesperrt ist und die Spannung am Einstellspannungseingang Vc keine Bedeutung hat, solange sie nicht negativ ist. Der Transistor T3 ist weiterhin gesperrt. Durch das niedrige Potential am Steuereingang 1 ist jetzt jedoch der Transistor T2 leitend, so daß die Drain des Transistors T0 mit dem Spannungseingang Vi gekoppelt ist und die Hochspannung Vh erhält, und ferner ist der Transistor T5 leitend, so daß das Steuergate GS des Transistors T0 direkt mit dem Schaltungsknoten Q der Schaltung verbunden ist, der die Hochspannung Vh führt. Der Transistor T6 ist damit unwirksam. Dieser Zustand ist in Fig. 2c angegeben. An der Source S des Transistors T0 und damit am Spannungsausgang Vo entsteht nun eine Programmierspannung, die um die vorher eingestellte Schwellspannung des Transistor T0 kleiner ist als die Hochspannung Vh am Spannungseingang Vi.

Es ist klar, daß der Schaltungsknoten Q auch direkt mit dem Spannungseingang Vi verbunden sein kann, so daß der Transistor T4 nur im zweiten Schritt des Einstellvorgangs über den Transistor T6 das Steuergate GS des Transistors T0 speist und im Normalbetrieb praktisch unwirksam ist. Dies ist eine Frage der praktischen Ausführung bzw. der Anordnung der Elemente auf dem Chip.

## Patentansprüche

1. Integrierte Speicheranordnung mit einer Matrix aus adressierbaren, elektrisch programmierbaren Speicherzellen, die je einen MOS-Transistor (TM) mit einem schwebenden, mittels einer Programmierspannung umladbaren Gate und einem Steuergate enthalten, und mit einer Steuerschaltung (C), die einen Spannungseingang (Vi) zum Zuführen einer Hochspannung größer als die gewünschte Programmierspannung, einen Spannungsausgang (Vo) zum Abgeben der Programmierspannung und einen zusätzlichen Transistor (T0) umfaßt, der gleich den Speicherzellen-Transistoren (TM) aufgebaut ist und dazu vorgesehen ist, aus der Hochspannung eine Programmierspannung mit nahezu optimalem Wert entsprechend Fertigungstoleranzen abzuleiten,
dadurch gekennzeichnet, daß die Source (S) des zusätzlichen Transistors (T0) mit dem Spannungsausgang (Vo) verbunden ist, daß die Drain (D) des zusätzlichen Transistors (T0) über einen ersten Schalter (T1) mit einem Steuerspannungseingang (Vc) und über einen zweiten Schalter (T2) mit dem Spannungseingang (Vi) koppelbar ist und daß das Steuergate (GS) des zusätzlichen Transistors (T0) über einen dritten Schalter (T3) mit der Bezugsspannung (0V) und wenigstens über einen vierten Schalter (T4) mit dem Spannungseingang (Vi) koppelbar ist.

2. Speicheranordnung nach Anspruch 1,
dadurch gekennzeichnet, daß bei Ausführung der Transistoren der Speicherzellen als N-Kanal-MOS-Transistoren der erste und der dritte Schalter (Tl, T3) als N-Kanal-MOS-Transistoren und der zweite und der vierte Schalter (T2, T4) als P-Kanal-MOS-Transistoren ausgebildet sind, wobei die Gates des ersten und zweiten Schalters (Tl, T2) gemeinsam über einen ersten Steuereingang (1) und die Gates des dritten und vierten Schalters (T3, T4) gemeinsam über einen zweiten Steuereingang (2) steuerbar sind.

3. Speicheranordnung nach Anspruch 2,
dadurch gekennzeichnet, daß zwischen dem vierten Schalter (T4) und dem Steuergate (GS) des zusätzlichen Transistors (T0) ein weiterer N-Kanal-MOS-Transistor (T6), dessen Gate mit dem mit dem vierten Schalter (T4) verbundenen Anschluß verbunden ist, geschaltet ist und daß über einen fünften Schalter (T5), der ebenfalls als P-Kanal-MOS-Transistor ausgebildet ist und über den ersten Steuereingang (1) steuerbar ist, das Steuergate (GS) des zusätzlichen Transistors (T0) mit dem Spannungseingang (Vi) koppelbar ist.

4. Verfahren zum Betrieb einer Speicheranordnung nach einem der Ansprüche 1 bis 3,
dadurch gekennzeichnet, daß die Programmierspannung an der Source (S) des zusätzlichen Transistors (T0) erzeugt wird, dessen Drain (D) im normalen Speicherbetrieb mit der Hochspannung gekoppelt ist und dessen Steuergate (GS) im wesentlichen auf dem Potential der Hochspannung liegt, und daß wenigstens vor dem erstmaligen Betrieb des Speichers dem zusätzlichen Transistor (T0) in einem ersten Einstellschritt an seinem Steuergate (GS) eine niedrige Spannung und an seiner Drain (D) im wesentlichen die Hochspannung während einer Zeitdauer zugeführt wird, die ausreicht, um den zusätzlichen Transistor (T0) vollständig zu programmieren und damit in den selbstleitenden Zustand zu bringen, und in einem zweiten Einstellschritt an seinem Steuergate (GS) im wesentlichen die Hochspannung und an seiner Drain (D) eine entsprechend den gewünschten Eigenschaften des Speichers im Betrieb zwischen der Bezugsspannung (0V) und einem Bruchteil der Hochspannung liegende Einstellspannung während einer Zeitdauer entsprechend der Programmierzeitdauer der Speicherzellen zugeführt wird.

## Revendications

1. Dispositif de mémoire intégré avec une matrice de cellules de mémoire adressables et programmables électriquement qui contiennent respectivement un transistor MOS (TM) avec une grille flottante rechargeable à l'aide d'une tension de programmation et une grille de commande et avec un circuit de commande (C) qui comprend une entrée de tension (Vi) en vue de l'alimentation d'une haute tension supérieure à la tension de programmation souhaitée, une sortie de tension (Vo) en vue de délivrer la tension de programmation et un transistor supplémentaire (T0) qui présente la même conception que les transistors des cellules de mémoire (TM) et est prévu pour dériver à partir de la haute tension une tension de programmation avec une valeur pratiquement optimale en fonction des tolérances de fabrication,
caractérisé en ce que la source (S) du transistor supplémentaire (T0) est reliée à la sortie de tension (Vo), que le drain (D) du transistor supplémentaire (T0) peut être couplé par l'intermédiaire d'un premier commutateur (T1) à une entrée de tension de commande (Vc) et par l'intermédiaire d'un deuxième commutateur (T2) à l'entrée de tension (Vi) et que la grille de commande (GS) du transistor supplémentaire (TO) peut être couplée par l'intermédiaire d'un troisième commutateur (T3) à la tension de référence (0V) et au moins par un quatrième commutateur (T4) à l'entrée de tension (Vi).

2. Dispositif de mémoire selon la revendication 1,
caractérisé en ce qu'en cas d'exécution des transistors des cellules de mémoire comme des transistors MOS de canal N, les premier et troisième commutateurs (T1, T3) sont conçus comme des transistors MOS de canal N et les deuxième et quatrième commutateurs (T2, T4) comme des transistors MOS de canal P, les grilles des premier et deuxième commutateurs (T1, T2) pouvant être commandées conjointement par l'intermédiaire d'une première entrée de commande (1) et les grilles des troisième et quatrième commutateurs (T3, T4) conjointement par l'intermédiaire d'une deuxième entrée de commande (2).

3. Dispositif de mémoire selon la revendication 2,
caractérisé en ce qu'entre le quatrième commutateur (T4) et la grille de commande (GS) du transistor supplémentaire (T0) est monté un transistor MOS à canal N supplémentaire (T6) dont la grille est reliée à la borne reliée au quatrième commutateur (T4) et que la grille de commande (GS) du transistor supplémentaire (T0) peut être couplée à l'entrée de tension (Vi) par l'intermédiaire d'un cinquième commutateur (T5) qui est conçu également comme un transistor MOS à canal P et peut être commandé par l'intermédiaire de la première entrée de commande (1)

4. Procédé d'exploitation d'un dispositif de mémoire selon l'une des revendications 1 à 3,
caractérisé en ce que la tension de programmation est produite à la source (S) du transistor supplémentaire (T0) dont le drain (D) est couplé en cas de fonctionnement normal de la mémoire à la haute tension et dont la grille de commande (GS) se trouve essentiellement au potentiel de la haute tension et qu'au moins avant la première mise en service de la mémoire, il est amené au transistor supplémentaire (T0) dans une première étape de réglage une tension inférieure à sa grille de commande (GS) et, essentiellement, la haute tension à son drain (D) pendant un intervalle de temps qui suffit pour programmer complètement le transistor supplémentaire (T0) et l'amener dès lors dans un état autoconducteur et il est amené dans une deuxième étape de réglage essentiellement la haute tension à sa grille de commande (GS) et une tension de réglage située entre la tension de référence (OV) et une fraction de la haute tension en fonction des propriétés souhaitées de la mémoire en service pendant un intervalle de temps correspondant à la durée de programmation des cellules de mémoire à son drain (D).

## Claims

1. An integrated storage arrangement, comprising a matrix of addressable, electrically programmable storage cells, each of which comprises a MOS transistor (TM) with a floating gate whose charge can be controlled by means of a programming voltage and each of which also comprises a control gate, the arrangement also comprising a control circuit (C) which comprises a voltage input (Vi) for receiving a high voltage which is higher than the desired programming voltage, a voltage output (Vo) for supplying the programming voltage, and an additional transistor (TO) whose construction is the same as that of the transistors (TM) of the storage cells and which serves to derive from the high voltage a programming voltage of substantially optimum value with a view to manufacturing tolerances, characterized in that the source (S) of the additional transistor (TO) is connected to the voltage output (Vo), that the drain (D) of the additional transistor (TO) can be coupled to a control voltage input (Vc), via a first switch (T1), and to the voltage input (Vi), via a second switch (T2), and that the control gate (GS) of the additional transistor (TO) can be coupled, via a third switch (T3), to the reference voltage (0 V) and, at least via a fourth switch (T4), to the voltage input (Vi).

2. A storage arrangement as claimed in claim 1, characterized in that, when the transistors of the storage cells are constructed as NMOS transistors, the first and the third switch (T1, T3) are constructed as NMOS transistors whereas the second and the fourth switch (T2, T4) are constructed as PMOS transistors, the gates of the first and the second switch (T1, T2) being controllable together via a first control input (1) whereas the gates of the third and the fourth switch (T3, T4) are controllable together via a second control input (2).

3. A storage arrangement as claimed in Claim 2, characterized in that between the fourth switch (T4) and the control gate (GS) of the additional transistor (TO) there is connected a further NMOS transistor (T6) whose gate is connected to the terminal connected to the fourth switch (T4), the control gate (GS) of the additional transistor (TO) being connectable to the voltage input (Vi) via a fifth switch (T5) which is also constructed as a PMOS transistor and can be controlled via the first control input (1).

4. A method of operating a storage arrangement as claimed in one of the Claims 1 to 3, characterized in that the programming voltage is generated at the source (S) of the additional transistor (TO) whose drain (D) is coupled to the high voltage during normal storage operation and whose control gate (GS) carries essentially the potential of the high voltage, that at least prior to the first activation of the memory the additional transistor (TO) receives, during a first adjustment step, a low voltage at its control gate (GS) and essentially the high voltage at its drain (D) for a period of time which suffices for complete programming of the additional transistor (T0), thus setting it to the normally-on state, and that, during a second adjustment step, for a period of time corresponding to the programming period of the storage cells essentially the high voltage is applied to its control gate (GS) whereas its drain (D) receives an adjusting voltage which lies between the reference voltage (0 V) and a fraction of the high voltage in conformity with the desired properties of the memory during operation.
